Europäisches Patentamt

European Patent Office

Office européen des brevets

(19)

(11) Numéro de publication : **0 051 019**
**B1**

(12)

# FASCICULE DE BREVET EUROPÉEN

(45) Date de publication du fascicule du brevet :
**05.09.84**

(51) Int. Cl.³ : **H 03 K 23/00**, H 03 K 21/18,
G 04 F 10/04, H 03 K 23/08,
H 03 K 23/30

(21) Numéro de dépôt : **81401641.6**

(22) Date de dépôt : **19.10.81**

(54) Dispositif pour le comptage d'impulsions de fréquence élevée.

(30) Priorité : **20.10.80 FR 8022416**

(43) Date de publication de la demande :
**05.05.82 Bulletin 82/18**

(45) Mention de la délivrance du brevet :
**05.09.84 Bulletin 84/36**

(84) Etats contractants désignés :
**AT BE CH DE GB IT LI NL SE**

(56) Documents cités :
**DE-B- 1 188 135
FR-A- 2 298 910
US-A- 3 420 990
US-A- 3 753 127
US-A- 3 805 031
US-A- 4 002 926
SEMICONDUCTOR CIRCUIT DESIGN, vol. 5, 1973
Texas Instruments BEDFORD (GB) G. CAVANAUGH
"Using the SN 74160 family of synchronous counters"
pages 125-130
ELECTRICAL DESIGN NEWS, volume 16, no. 8, 15
avril 1971 DENVER (US) HANNON: "Give second
thought to invalid conditions" pages 10100-10101**

(73) Titulaire : **ELECTRONIQUE SERGE DASSAULT
80, avenue Marceau
F-75008 PARIS (FR)**

(72) Inventeur : **Geesen, Michel
48, rue des Mûres
F-92160 Antony (FR)**

(74) Mandataire : **Netter, André et al
Cabinet NETTER 40, rue Vignon
F-75009 Paris (FR)**

## Description

L'invention a pour objet un dispositif pour le comptage d'impulsions notamment de fréquence élevée.

On sait que lorsqu'il s'agit de compter un nombre élevé d'impulsions électriques, notamment pour la mesure d'intervalles de temps, on doit faire appel à un dispositif de comptage à plusieurs étages, ou compteurs élémentaires.

La détermination d'une durée, ou d'un intervalle de temps entre deux événements, peut s'effectuer en faisant débuter le comptage des impulsions d'un signal d'horloge à l'arrivée d'un ordre correspondant au premier événement, et cesser ce comptage à l'arrivée d'un ordre correspondant au deuxième événement. La différence entre les niveaux de compte au début et à la fin du comptage correspond au nombre d'impulsions reçues entre les deux ordres et est représentative de l'intervalle de temps recherché. Selon ce mode opératoire, il est en général loisible de faire débuter le comptage à partir d'un état où tous les étages du dispositif de comptage sont à 0, l'état du dispositif de comptage au moment de la cessation du comptage correspondant alors directement au nombre recherché.

Il existe un deuxième mode de comptage dans lequel on utilise un compteur en fonctionnement permanent et on lit les états instantanés de ce compteur lors du début et de la fin de la période que l'on cherche à mesurer.

Dans ce système, le compteur est alimenté en permanence par un signal d'horloge. A la réception d'un premier ordre correspondant à un premier événement, on lit l'état du compteur à l'aide d'un registre à étages dont les étages sont connectés respectivement aux étages du compteur et que l'on valide temporairement pour charger dans le registre une valeur correspondant à l'état instantané de ce compteur. Ce registre, ou un deuxième registre connecté de la même façon que le premier registre aux différents étages du compteur, est ensuite validé en réponse à un ordre de fin de comptage correspondant à un deuxième événement afin de charger dans le registre un compte correspondant à l'état instantané du compteur au moment de la réception de ce deuxième ordre. Il est facile de déduire des indications enregistrées dans les premier et second registres la mesure du temps séparant les premier et deuxième événements.

Pour que le comptage soit exact, lorsqu'on utilise ce deuxième mode, il importe qu'à l'arrivée desdits ordres de début et de fin de comptage, chacun des étages du compteur soit dans la condition qui correspond effectivement au nombre d'impulsions d'horloge comptées au moment de l'arrivée dudit ordre.

Si cette condition est réalisée dans le cas où les étages, ou compteurs élémentaires, dont la succession constitue le dispositif de comptage, sont attaqués simultanément par les impulsions d'horloge à compter (compteurs communément appelés « synchrones »), il n'en est pas de même lorsque les étages sont montés les uns à la suite des autres de manière qu'un étage de rang n soit attaqué par l'étage de rang immédiatement précédent (n − 1). Le fonctionnement de chaque étage exige en effet un temps qui, pour être très bref, n'en est pas moins existant, de sorte que, pour des étages ainsi montés en série ou compteurs asynchrones, la commutation d'un étage de rang relativement élevé se fait après qu'un intervalle de temps notable se soit écoulé depuis l'arrivée sur l'étage de poids le plus faible de l'impulsion d'horloge à laquelle doit correspondre ladite commutation.

Si la fréquence des signaux d'horloge utilisés pour le comptage est très élevé, il peut se faire que la commutation des étages de poids les plus élevés du compteur en réponse à une impulsion ne soit pas encore terminée lorsque la lecture du compteur doit être effectuée. En conséquence, avec un tel dispositif de comptage, il n'est pas exclu que, lors de l'arrivée d'un ordre de début ou de fin de comptage qui commande la lecture du contenu des différents étages du compteur par un registre de lecture, l'état de chacun des étages ne corresponde pas effectivement au nombre d'impulsions reçues à l'entrée du compteur.

On a donc jusqu'ici limité l'utilisation des compteurs asynchrones à fonctionnement permanent et lecture au vol aux cas où les impulsions à compter n'ont pas une fréquence trop grande. Lorsqu'il n'en est pas ainsi, on utilise des compteurs synchrones, c'est-à-dire à étages attaqués simultanément par les impulsions à compter. De tels dispositifs de comptage sont chers et entraînent une consommation relativement importante d'énergie électrique.

Dans ce domaine, on connaît par ailleurs des compteurs d'impulsions à fréquence élevée qui sont destinés à diviser le nombre d'impulsions entrantes par un nombre N fixé à l'avance, par exemple par programmation (Brevet des Etats-Unis n° 4 002 926 — Moyer et n° 3 420 990 — ANDREA et al.). Ces documents antérieurs prévoient tous deux l'association d'un compteur synchrone et d'un compteur asynchrone pour fonctionner en réponse à des impulsions qui peuvent avoir une fréquence élevée. Mais ils n'enseignent aucune solution au problème de la lecture synchrone du compte d'impulsions reçues, problème qui demeure donc entier.

L'invention propose un type de compteur d'impulsions destiné particulièrement au comptage d'impulsions de fréquence élevée.

Conformément à l'invention, il est prévu un dispositif de comptage d'impulsions de fréquence élevée du type comprenant des moyens de comptage d'impulsions à plusieurs étages de poids croissants, les étages de poids inférieur de ces moyens de comptage étant montés en compteur synchrones et les étages de poids supérieur en compteur asynchrone, caractérisé en ce que des moyens sont prévus pour commander la commutation dudit compteur asynchrone en avance par rapport à l'instant de réception à l'entrée desdits moyens de comptage de l'impulsion dont le rang correspond à cette commutation, et en ce que le dispositif comporte des moyens de lecture synchrone du compte d'impulsions reçues qui comprennent un moyen de commande systématique du relevé de l'état du compteur asynchrone en correspondance du passage dudit compteur synchrone à un état prédéterminé.

Selon un mode de réalisation préféré, les moyens de commande de la commutation anticipée du compteur asynchrone comprennent des moyens propres à détecter le passage du compteur synchrone à un état prédéterminé pour déclencher la commutation de l'étage de poids le plus faible de ce compteur asynchrone. En outre, on prévoit avantageusement de réaliser le moyen de commande systématique du relevé du compteur asynchrone à l'aide d'un décodeur de l'état du compteur synchrone, qui peut être notamment sensible au dépassement de sa pleine capacité par ledit compteur synchrone.

La valeur de l'avance à la commutation du compteur asynchrone est déterminée de façon qu'elle soit supérieure à l'intervalle de temps maximal nécessaire à la stabilisation de ce compteur asynchrone en réponse à la réception d'une impulsion sur son entrée. A cet effet, on choisit avantageusement le nombre d'étages du compteur synchrone de manière que la période séparant des commutations successives de l'étage le plus faible du compteur asynchrone, à la fréquence maximale des impulsions d'entrée, soit supérieure à cet intervalle de temps maximal de stabilisation. De préférence, en outre, on s'arrange pour que cet intervalle de temps de stabilisation soit inférieur à la demi-période des impulsions de dépassement de sa pleine capacité du compteur synchrone afin de disposer d'une marge de temps suffisante pour effectuer la lecture de l'état de ce compteur asynchrone une fois stabilisé, avant que n'intervienne l'impulsion de commutation suivante de ce compteur.

L'invention part donc de cette constation que si la fréquence de commutation des étages d'un dispositif de comptage est très élevée pour le premier étage, ou étage de plus faible poids, puisqu'elle est alors égale à la fréquence des impulsions à compter, elle diminue rapidement pour les étages suivants qui sont affectés de poids plus élevés, jusqu'à devenir inférieure à celle qui correspond au retard de fonctionnement inhérent au montage en série des étages d'un compteur asynchrone.

Conformément à un aspect avantageux de l'invention, les moyens de lecture comprennent un registre connecté aux étages du compteur asynchrone pour en effectuer la lecture systématique en réponse à une commande émise après que se soit écoulé un intervalle de temps minimum à la suite de chaque commande de commutation anticipée de l'étage de poids le plus faible du compteur asynchrone, cet intervalle de temps étant suffisant pour que toutes les commutations consécutives des étages de ce compteur soient achevées et que son état soit en conséquence stabilisé.

Pour la lecture de l'état instantané du dispositif de comptage, on utilise avantageusement deux registres, l'un connecté à la sortie des étages asynchrones et l'autre connecté à la sortie des étages synchrones pour la lecture de ces derniers sous la commande d'une impulsion d'ordre de lecture. Selon un mode de réalisation, cet ordre de lecture effectue également le blocage du transfert du compteur asynchrone dans son registre associé.

Dans ces conditions, à la suite de l'ordre de lecture on dispose, dans le premier registre, de l'état instantané du compteur synchrone et, dans le registre affecté au compteur asynchrone, de l'état dans lequel se trouvait ce dernier au moment de l'impulsion d'ordre de lecture. Si cette impulsion de lecture intervient après que le compteur asynchrone s'est stabilisé et au moment où l'impulsion de comptage correspondant à cet état stable parvient au dispositif de comptage, on évite de transmettre au registre affecté au compteur asynchrone des informations erronées sur l'état instantané de ce dernier, tout en exploitant la faculté d'avancer l'instant de commutation de ce compteur asynchrone.

Un mode de réalisation consiste à commander le registre de lecture associé au compteur asynchrone par une impulsion correspondant au dépassement par le compteur synchrone de sa pleine capacité, tandis que l'on commande la commutation de l'étage de plus faible poids de ce compteur asynchrone en réponse à un changement d'état dans le compteur synchrone précédant le dépassement par ce dernier de sa pleine capacité. De préférence, on effectue cette commutation anticipée à la moitié de la période de comptage du compteur synchrone à sa pleine capacité.

Lorsqu'on désire déterminer des intervalles de temps par lecture des états instantanés du dispositif de comptage au début et à la fin de cet intervalle, il peut être prévu une première et une deuxième mémoires susceptibles d'enregistrer les états des registres respectivement au début et à la fin de l'intervalle de temps considéré.

Dans la description qui suit, faite à titre d'exemple, on se réfère aux dessins annexés, dans lesquels :

la figure 1 est un schéma synoptique d'un dispositif de comptage mettant en œuvre l'invention ;

la figure 2 est un diagramme de signaux mis en œuvre dans le dispositif de la figure 1.

Un compteur synchrone 10 à quatre étages binaires, dans cet exemple, respectivement $10_1$ à $10_4$ en allant de l'étage de poids le plus faible vers l'étage de poids le plus élevé, est combiné à un compteur de type asynchrone 12 à n étages binaires numérotés respectivement de $12_1$ à $12_n$ par ordre de poids croissants.

Le compteur synchrone 10 reçoit, à partir d'une ligne d'entrée 15, des impulsions H de fréquence élevée, par exemple en provenance d'une horloge fonctionnant à 15 MHz. Ces impulsions sont dirigées sur des entrées $14_1$ à $14_4$ respectives des étages $10_1$ à $10_4$. Chaque étage $10_1$ à $10_4$ est relié au précédent par une liaison d'autorisation de commutation en fonction de l'état de cet étage précédent selon le principe connu du montage des compteurs synchrones. Ainsi, par exemple, l'étage $10_1$ commute entre ses deux états logiques possibles 0 et 1 à chaque impulsion sur son entrée $14_1$, tandis que l'étage $10_2$ commute en réponse à une impulsion sur deux, sur son entrée $14_2$ à savoir, par exemple, seulement quand l'étage $10_1$ est au niveau logique 1. La commutation de chacun des étages $10_1$ à $10_4$ se fait pratiquement simultanément avec la réception de l'impulsion qui la provoque, chaque autorisation de commutation interne intervenant en réponse à une commutation précédente de l'étage d'où émane l'autorisation.

Au contraire, le compteur asynchrone 12 possède une seule entrée 16 sur son étage de poids le plus faible $12_1$. Chaque impulsion arrivant sur cet étage provoque la commutation de celui-ci entre ses deux états, tandis que l'étage suivant $12_2$, qui commute en réponse au seul passage de l'état 0 à l'état 1 de l'étage $12_1$, commute avec une fréquence deux fois plus faible et avec un léger retard par rapport à l'impulsion qui provoque la commutation de l'étage $12_1$. Ce processus se poursuit au niveau des étages de poids croissant du compteur asynchrone, dont les commutations respectives se produisent à des fréquences de plus en plus faibles et avec des retards par rapport au moment de l'arrivée de l'impulsion respective sur l'entrée 16 de plus en plus grands, qui correspondent à la somme des retards à la commutation des étages précédents.

Les impulsions présentes à l'entrée 16 du compteur asynchrone 12 sont issues de la sortie d'état $24_4$ de l'étage $10_4$.

En raison de cette connexion entre le compteur synchrone 10 et le compteur asynchrone 12, une impulsion est présente à l'entrée 16 du compteur asynchrone 12, chaque fois que l'état du compteur synchrone 10 passera de l'état 1110 à l'état 0001, les bits de gauche à droite représentant les états des étages $10_1$ à $10_4$ dans cet ordre. Ainsi, l'impulsion à l'entrée 16 du compteur asynchrone est produite, non pas quand le compteur synchrone passe de l'état 1111 à l'état 0000, c'est-à-dire quand il dépasse sa pleine capacité (comme il est habituel dans les montages de compteurs en série) mais en avance par rapport à cet instant et donc par rapport à l'arrivée sur l'entrée 15 de l'impulsion d'horloge H dont le rang correspond à celui de l'étage $12_1$ dans le compteur asynchrone (12). Dans cet exemple, la commutation de l'étage $12_1$ correspond à l'arrivée d'une impulsion H de rang 16 à l'entrée 15, mais elle est commandée avec une avance égale à une demi-période de commutation de l'étage $10_4$, c'est-à-dire le dernier étage du compteur synchrone.

Les sorties d'état du compteur synchrone 10 sont numérotées respectivement, de $24_1$ à $24_4$ et reliées à des entrées $26_1$ à $26_4$ respectivement d'un registre de lecture 27 ayant une autre entrée de commande 28 raccordée à la sortie Q63 d'une bascule 42 de type D dont l'entrée d'horloge 44 est raccordée à l'entrée d'horloge 15, et dont l'autre entrée D46 est branchée à la sortie Q60 d'une bascule 62 de type D. Le registre 27 possède une sortie à quatre bits 31 reliés aux quatre bits d'entrée de poids inférieur 32 d'une mémoire 33 de $4 + n$ bits, dite mémoire de début de comptage. La sortie 31 est également reliée aux quatre bits d'entrée 34 de poids inférieur d'une deuxième mémoire 35, dite mémoire de fin de comptage. Chacune des mémoires 33 et 35 possède une entrée de commande, respectivement 37 et 39, reliée à la sortie d'une porte ET72, respectivement ET74, afin de recevoir un ordre de transfert de début de comptage pour la mémoire 33 et un ordre de transfert de fin de comptage pour la mémoire 35 sur des lignes respectives 41 et 43 aboutissant sur les entrées 71 et 73 des portes ET72 et ET74 respectivement, dont les autres entrées 75, respectivement 76, sont reliées à la sortie Q63 de la bascule 42. Les lignes 41 et 43 sont reliées par l'intermédiaire d'une porte OU45 à l'entrée d'horloge 66 de la bascule 62, dont l'entrée D68 est polarisée à un niveau fixé.

Le compteur asynchrone possède des sorties d'état de ses étages $47_1$ à $47_n$ reliées par une liaison multibits aux n entrées 48 d'un registre 49 dont la sortie à n bits 51 est connectée, d'une part, aux n bits d'entrée de poids supérieur 53 de la mémoire de début de comptage 33 et, d'autre part, aux n bits d'entrée de poids supérieur 55 de la mémoire de fin de comptage 35. Les liaisons bit à bit entre les registres 27 et 49, d'une part, et les mémoires 35 et 33, d'autre part, sont effectuées dans l'ordre.

Le registre 49 possède une entrée de commande 56 raccordée à la sortie d'un inverseur 57 recevant sur son entrée les signaux d'état de la sortie $24_4$ de l'étage $10_4$ du compteur synchrone 10.

En fonctionnement, les compteurs 10 et 12 sont incrémentés sous l'action des impulsions d'horloge H à haute fréquence présentes sur la ligne 15, le compteur 12 recevant des commandes d'incrémentation sur son entrée 16 en avance sur l'instant d'arrivée sur la ligne 15 des impulsions dont le rang correspond normalement à la commutation de son étage de poids le plus faible $12_1$.

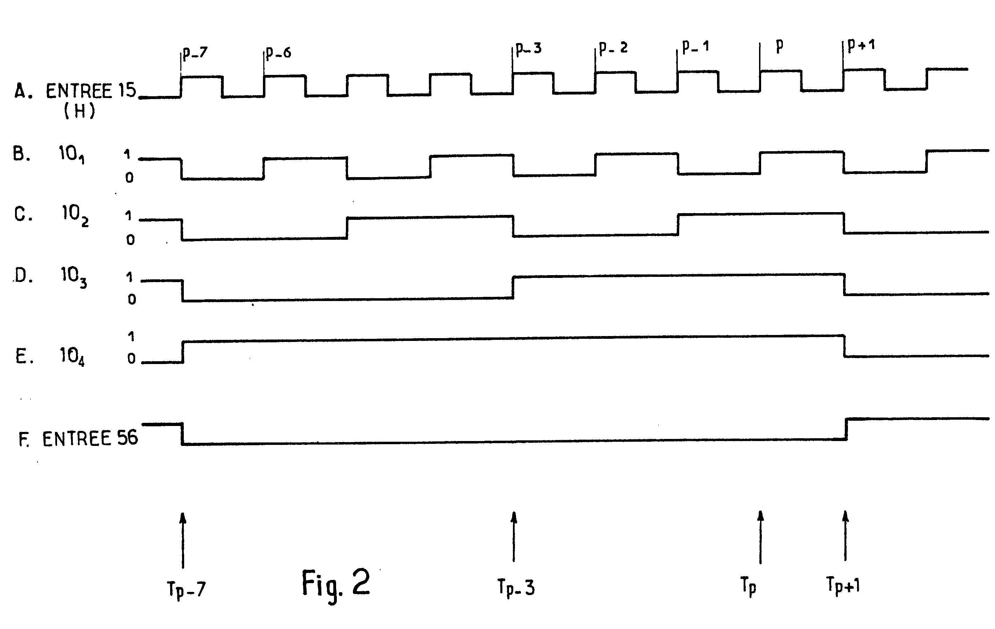

La figure 2A représente, dans le temps, les signaux d'horloge présents sur l'entrée 15.

Les figures 2B à 2E représentent dans cet ordre les signaux d'état des étages $10_1$ à $10_4$ du compteur synchrone 10. L'instant $T_P$ marque le moment où le compteur 10 atteint sa pleine capacité. Il est suivi, au moment de l'impulsion d'horloge suivante de rang $p + 1$, d'un retour à zéro de tous les étages qui devrait normalement correspondre à la commutation de l'état $12_1$ du compteur asynchrone.

En fait, si on se réfère à la figure 2E représentant le signal à la sortie de l'étage $24_4$, on constate que l'application d'un signal de commutation à l'étage $12_1$ se produit à l'instant $T_{p-7}$, soit huit impulsions d'horloge avant le temps où cette commutation devrait normalement se produire. La durée de cet intervalle de huit impulsions est suffisante pour que la commutation éventuelle de chaque étage du compteur asynchrone changeant d'état en réponse à la commande d'entrée 16 ait eu le temps de s'effectuer avant la fin de l'intervalle. Autrement dit, si l'impulsion reçue sur l'entrée 16 correspond à un changement d'état de l'étage de poids le plus fort $12_n$, il est prévu que le temps de propagation de l'impulsion de commutation, par la commutation successive des étages $12_1$ à $12_n$, soit inférieur à la durée cumulée des huit impulsions d'horloge. Ce temps de propagation est une donnée pour un compteur asynchrone possédant un nombre d'étages n déterminé. Connaissant la fréquence d'arrivée des impulsions d'horloge H sur l'entrée 15, il est possible de sélectionner le nombre de bits du compteur synchrone 10 — qui, dans cet exemple, pour la simplicité des explications, a été choisi égal à quatre, mais qui, en pratique, peut être plus ou moins élevé, par exemple de huit bits — de façon que la fréquence de fonctionnement du compteur asynchrone soit suffisamment basse pour permettre sa stabilisation complète entre l'instant d'arrivée d'une impulsion sur son entrée 16 et celui de l'impulsion suivante ; et l'on avance suffisamment l'instant d'émission par le compteur synchrone des impulsions vers l'entrée 16 pour que cette stabilisation ait eu le temps de s'effectuer au moment où le contenu du compteur synchrone 10 reçoit l'impulsion de dépassement de sa pleine capacité.

Certaines dispositions sont prévues, conformément à un aspect de l'invention, au niveau de la lecture du compteur asynchrone 12.

L'entrée 56 qui commande le chargement dans le registre de lecture 49 des états des étages $12_1$ à $12_n$ est commandée, à travers un inverseur 57, par la sortie $24_4$ de l'étage $10_4$. Le signal correspondant est représenté sur la figure 2F. Le front ascendant du signal de commande, qui effectue ce transfert, se produit à l'instant $T_{p+1}$, c'est-à-dire à un moment où la commutation de tous les étages du compteur asynchrone 12 a eu le temps de se stabiliser conformément à la règle qui vient d'être indiquée précédemment. Ce transfert se produit en outre à un moment où le nombre d'impulsions H reçues à l'entrée 15 du compteur correspond effectivement à l'état de commutation enregistré dans le compteur asynchrone 12, et le prochain enregistrement dans le registre de lecture 49 sera effectué après la réception de la prochaine impulsion sur l'entrée 16, mais seulement lorsque les effets de celle-ci auront eu le temps de se stabiliser dans le compteur asynchrone 12.

On constate donc que, d'une part, la lecture des états du compteur asynchrone 12 par le registre de lecture 49 s'effectue de façon systématique en réponse au compteur synchrone 10 et, d'autre part, que cette lecture s'effectue toujours à un moment où l'état du compteur asynchrone 12 est stable et correspond à un compte d'impulsions d'horloge H effectivement reçues par le dispositif de comptage à l'instant où la lecture est effectuée.

Le transfert du contenu du compteur synchrone 10 dans le registre de lecture 27 est effectué, quant à lui, par la commande de son entrée 28 en réponse à un ordre de lecture provenant de la ligne 41, ou de la ligne 43, à travers la porte OU45 qui excite l'entrée d'horloge 66 de la bascule 62 en provoquant l'excitation de sa sortie Q60 et la mise à un de l'entrée D46 de la bascule 42.

L'impulsion d'horloge suivant immédiatement l'apparition de l'ordre de lecture à la sortie de la porte OU45 provoque, par l'entrée d'horloge 44 de la bascule 42, l'excitation de la sortie Q63 de la bascule 42. Le signal de la sortie Q63 effectue, d'une part, la remise à zéro par l'entrée RAZ de la bascule 60 et commande, d'autre part, la charge dans le registre 27 des états du compteur 10, par l'entrée 28, et la validation des portes ET72 et 74.

Lorsqu'une impulsion de début de comptage apparaît sur la ligne 41, elle provoque à travers la porte ET72 et par l'entrée 37, la mise en mémoire de début de comptage 33 des contenus du registre de lecture 27 et du registre de lecture 49. Le nombre mis en mémoire 33 correspond bien, ainsi qu'il a été expliqué ci-dessus, au nombre d'impulsions d'horloge H ayant été admises à l'entrée 15 du dispositif de comptage et comptées par la combinaison des compteurs 10 et 12 au moment de la réception de l'impulsion sur la ligne 41.

Lorsqu'une impulsion de fin de comptage apparaît sur la ligne 43, un processus de transfert identique est mis en œuvre à partir des contenus des registres de lecture 27 et 49 en direction de la mémoire de fin de comptage 55 dont l'entrée 39 est commandée à partir de l'impulsion de la ligne 43.

Les comptes de début de comptage et de fin de comptage mis en mémoire dans les mémoires 33 et 35 sont disponibles en vue d'un traitement ou d'une transmission, notamment afin de déterminer l'intervalle de temps écoulé entre les deux commandes de lecture.

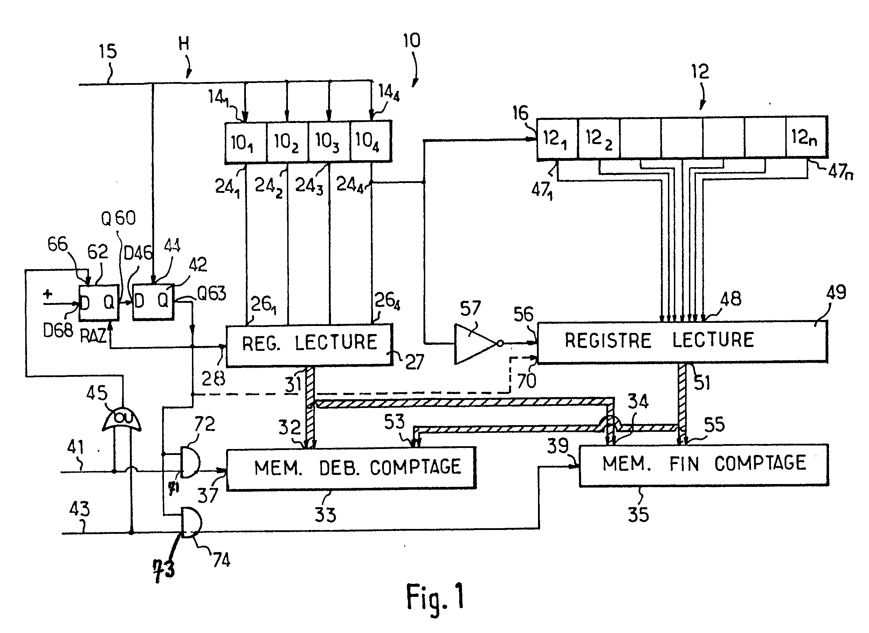

Si la vitesse de transfert du contenu du registre de lecture 49 dans les mémoires de 33 et 35 n'est pas suffisamment élevée pour que la lecture soit effectuée en un temps inférieur à une période de l'horloge 15, il est prévu de bloquer momentanément le contenu de ce registre 49 à la réception d'un ordre de transfert de début ou de fin de comptage, jusqu'à ce que le transfert ait eu le temps de s'achever. Ce blocage peut être effectué par l'application du signal à la sortie Q63 de la bascule 42 sur une entrée 70 du registre 49 par une ligne figurée en tirets sur la figure 1. Cette solution est convenable si l'intervalle entre deux ordres de transfert est tel qu'au moins une nouvelle lecture systématique du compteur 12 par le registre 49 ait eu lieu après la fin de la mise en mémoire consécutive à une première impulsion de transfert et avant l'impulsion de transfert suivante.

Suivant une variante, si cette condition n'est pas respectée, on peut utiliser deux registres de lecture de l'ensemble compteur synchrone et asynchrone en parallèle en commandant le blocage de l'un pendant que l'autre est disponible pour la lecture de ces compteurs.

Les dispositions qui viennent d'être décrites permettent d'obtenir un dispositif de comptage ayant une très grande capacité et susceptible de fonctionner à une haute fréquence, par exemple plusieurs dizaines de mégahertz tout en requérant un minimum de matériel. En particulier, on peut limiter le nombre d'étages synchrones nécessaires strictement en considération du temps de commutation en cascade de la totalité des étages du compteur asynchrone envisagés. Même avec des fréquences très élevées, il suffit d'un nombre relativement peu élevé d'étages de compteur synchrone pour obtenir une fréquence de sortie suffisamment basse pour alimenter des étages asynchrones dans des conditions satisfaisantes. On économise sur la complexité du compteur, par rapport à un dispositif dans lequel tous les étages seraient synchrones, avec un gain correspondant non seulement en coût mais également en consommation d'énergie.

En ce qui concerne le coût du matériel utilisé et sa consommation, on peut se limiter à utiliser une technologie électronique très rapide telle que la technologie ECL ou TTL pour la réalisation des quelques étages du compteur synchrone. Le compteur asynchrone peut être réalisé avantageusement dans une technologie, MOS par exemple, dont les consommations en énergie sont, de façon inhérente, très faibles.

A titre d'exemple, on peut, avec une série de huit étages montés en compteur synchrone suivie de vingt-quatre étages montés en asynchrone, réaliser un compteur ayant une période de plusieurs minutes entre deux états de pleine capacité, lorsqu'il est alimenté par une fréquence d'horloge pouvant être supérieure à la dizaine de mégahertz. Les étages synchrones sont capables, compte tenu de la technologie utilisée, de fonctionner à plusieurs dizaines de MHz ou plus. En revanche, les étages asynchrones fonctionnent à une fréquence de l'ordre de quelques dizaines de kHz. Un temps de propagation type d'une commutation affectant, jusqu'à son étage de poids le plus fort, un tel compteur asynchrone peut être de plusieurs microsecondes.

Il faut noter enfin que les principes de commutation anticipée d'un compteur asynchrone et de lecture systématique de ce compteur peuvent être appliqués à des combinaisons de comptage comportant plusieurs compteurs asynchrones en série réalisés dans des technologies différentes dont les vitesses de fonctionnement sont d'autant plus faibles que les poids affectés aux compteurs correspondants dans la combinaison sont plus grands.

**Revendications**

1. Dispositif de comptage d'impulsions de fréquence élevée du type comprenant des moyens de comptage d'impulsions à plusieurs étages de poids croissants, les étages de poids inférieur de ces moyens de comptage étant montés en compteur synchrone (10) et les étages de poids supérieur en compteur asynchrone (12), caractérisé en ce que des moyens sont prévus pour commander la commutation dudit compteur asynchrone en avance par rapport à l'instant de réception à l'entrée desdits moyens de comptage de l'impulsion dont le rang correspond à cette commutation, et en ce que le dispositif comporte des moyens de lecture synchrone (27, 49) du compte d'impulsions reçues qui comprennent un moyen de commande systématique du relevé de l'état du compteur asynchrone (12) en correspondance du passage dudit compteur synchrone (10) à un état prédéterminé.

2. Dispositif selon la revendication 1, caractérisé en ce que le nombre d'étages du compteur synchrone (10) est déterminé pour que la période séparant deux commutations successives de l'étage de plus faible poids du compteur asynchrone (12), à la fréquence maximale des impulsions d'entrée, soit supérieur à l'intervalle de temps maximum nécessaire à la commutation des étages de compteur asynchrone en réponse à une impulsion de commande à l'entrée de celui-ci.

3. Dispositif selon la revendication 1, caractérisé en ce que les moyens de commande de la commutation du compteur asynchrone (12) comportent des moyens ($24_4$) pour détecter le passage à un état prédéterminé du compteur synchrone (10) et déclencher la commutation de l'étage de poids le plus faible du compteur asynchrone (12) en réponse à cette détection.

4. Dispositif selon l'une des revendications 1 à 3, caractérisé en ce que ledit moyen de commande systématique du relevé desdits étages du compteur asynchrone comprend un moyen de décodage de l'état dudit compteur synchrone ($24_4$, 57).

5. Dispositif selon la revendication 4, caractérisé en ce que lesdits moyens de commande de relevé systématique sont propres à transmettre un signal de relevé en réponse au dépassement de sa pleine capacité par le compteur synchrone (10).

6. Dispositif selon l'une des revendications 1 à 5, caractérisé en ce que lesdits moyens de lecture comprennent un premier registre (49) connecté pour la lecture des étages du compteur asynchrone en réponse auxdits moyens de commande de relevé systématique.

7. Dispositif selon la revendication 6, caractérisé en ce que les moyens de lecture comprennent un deuxième registre (27) connecté pour la lecture des étages du compteur synchrone (10) en réponse à un ordre de lecture.

8. Dispositif selon la revendication 7, caractérisé en ce qu'il comprend une première mémoire (33) pour enregistrer l'état desdits premier et deuxième registres à la réception d'un ordre de lecture correspondant à une commande de début de comptage et une deuxième mémoire (35) pour enregistrer l'état des registres à la réception d'un ordre de lecture correspondant à une commande de fin de comptage.

9. Dispositif selon la revendication 2, caractérisé en ce que lesdits moyens de lecture comprennent un registre (49) et les moyens de commande de relevé systématique sont opératoires pour commander la lecture de l'état du compteur asynchrone dans ce registre, en réponse à la réception par les moyens de comptage de l'impulsion déclenchant la commutation de l'étage de poids le plus faible du compteur asynchrone.

10. Dispositif selon la revendication 9, caractérisé en ce que les moyens de commande de commutation du compteur asynchrone comprennent des moyens ($24_4$) pour indiquer un premier changement d'état du compteur synchrone et déclencher (16) la commutation du compteur asynchrone en réponse à cette indication, et les moyens de commande de relevé systématique comprennent des moyens ($24_4$ et 57) pour indiquer un deuxième changement d'état du compteur synchrone (10) suivant le premier et déclencher (56) la lecture du contenu du compteur asynchrone par ledit registre en réponse à cette indication.

11. Dispositif selon la revendication 10, caractérisé en ce que le deuxième changement d'état correspond à la commutation du compteur synchrone (10) correspondant au dépassement de son état de pleine capacité, et le premier changement d'état correspond à la commutation de l'étage de poids le plus élevé du compteur synchrone (10) précédant l'état de pleine capacité.

12. Dispositif selon l'une des revendications 6, 7 ou 9 ou 11, caractérisé en ce qu'il comprend des moyens pour mettre en mémoire le contenu du registre (49) de lecture du compteur asynchrone (12) en réponse à un ordre de transfert et des moyens (70) pour bloquer le registre de lecture pendant le temps de cette mise en mémoire.

**Claims**

1. A high frequency pulse counter of the type comprising a plurality of pulse counting stages of increasing significance, the less significant stages being connected as a synchronous counter (10) and the more significant stages being connected as an asynchronous counter (12), characterized in that means are provided for causing said asynchronous counter to switch in advance of the instant at which the input of said pulse counter stage receives the pulse of rank corresponding to said switching, and in that the counter includes synchronous read means (27, 49) for reading the received pulse count, which read means include systematic read control means for systematically reading the state of the asynchronous counter (12) whenever said synchronous counter (10) passes to a predetermined state.

2. A counter according to claim 1, characterized in that the number of synchronous counter (10) stages is so determined that the period between two successive switches of the least significant stage of the asynchronous counter (12) at the maximum input pulse frequency is greater than the maximum time interval required for the stages of the asynchronous counter to switch in response to a control pulse at the input thereof.

3. A counter according to claim 1, characterized in that the means for controlling switching of the asynchronous counter (12) include means ($24_4$) for detecting the passage of the synchronous counter (10) to a predetermined state in order to trigger switching of the least significant stage of the asynchronous counter (12) in response to such detection.

4. A counter according to any one of claims 1 to 3, characterized in that said systematic read control means include means ($24_4$, 57) for decoding the state of said synchronous counter.

5. A counter according to claim 4, characterized in that said systematic read control means are suitable for transmitting a read signal in response to the synchronous counter (10) overflowing its full capacity.

6. A counter according to any one of claims 1 to 5, characterized in that said read means include a first register (49) connected to read the stages of the asynchronous counter in response to said systematic read control means.

7. A counter according to claim 6, characterized in that the read means include a second register (27) connected to read the stages of the synchronous counter (10) in response to a read instruction.

8. A counter according to claim 7, characterized in that it includes a first memory (33) for storing the state of said first and second registers on receiving a beginning of count command, and a second memory (35) for storing the state of the registers on receiving a read instruction corresponding to an end of count command.

9. A counter according to claim 2, characterized in that said read means include a register (49) and the systematic read control means are operational for causing the state of the asynchronous counter to be read into said register in response to the counting means receiving the pulse triggering switching of the least significant stage of the asynchronous counter.

10. A counter according to claim 9, characterized in that the control means of the asynchronous counter include means ($24_4$) for indicating a first change of state of the synchronous counter and for triggering (16) switch of the asynchronous counter in response to this indication, and the systematic read control means include means (24$_4$ and 57) for indicating a second change of state of the synchronous counter (10) following the first and for trigerring (56) reading of the contents of the asynchronous counter by said register in response to this indication.

11. A counter according to claim 10, characterized in that the second change of state corresponds to the synchronous counter (10) overflowing from its full state, and the first change of state corresponds to the switching of the most significant stage of the synchronous counter (10) prior to reaching full capacity.

12. A counter according to claim 6, 7, 9 or 11, characterized in that the counter includes means for storing the contents of the asynchronous counter (12) read register (49) into the memory in response to a transfer instruction and means (70) for locking the read register during the time take for this storage.

**Ansprüche**

1. Vorrichtung zum Zählen von Impulsen mit erhöhter Frequenz derjenigen Art, die Mittel zum Zählen von Impulsen mit mehreren Stufen mit steigenden Wertigkeiten aufweist, wobei in diesen Zählmitteln die Stufen mit geringerer Wertigkeit als synchrones Zählwerk (10) und die Stufen mit höherer Wertigkeit als asynchrones Zählwerk (12) ausgebildet sind, dadurch gekennzeichnet, daß Mittel vorgesehen sind, um die Kommutation des besagten asynchronen Zählwerkes vor dem Zeitpunkt des Empfanges des Impulses, dessen Rang der Kommutation entspricht, am Eingang besagter Zählmittel zu steuern, und daß die Vorrichtung Mittel für das synchrone Lesen (27, 49) des Zählens der empfangenen Impulse enthält, die ein Mittel zur systematischen Steuerung des Lesens des Zustandes des asynchronen Zählwerks (12) in Übereinstimmung mit dem Übergang des besagten synchronen Zählwerks (10) in einen vorherbestimmten Zustand aufweist.

2. Vorrichtung nach Anspruch 1, dadurch gekennzeichnet, daß die Anzahl der Stufen des synchronen Zählwerkes (10) so bestimmt ist, daß die Periode, die zwei aufeinanderfolgende Kommutationen der Stufe von geringerer Wertigkeit des asynchronen Zählwerkes (12) trennt, bei maximaler Frequenz der Eingangsimpulse, größer ist als das größte Zeitintervall, das für die Kommutation der Stufen des asynchronen Zählwerkes aufgrund eines Steuerimpulses an dessen Eingang notwendig ist.

3. Vorrichtung nach dem Anspruch 1, dadurch gekennzeichnet, daß die Steuerungsmittel für die Kommutation des asynchronen Zählwerkes (12) Mittel (24$_4$) aufweisen, um den Übergang des synchronen Zählwerks (10) in einen vorherbestimmten Zustand zu erfassen und die Kommutation der Stufe mit geringster Wertigkeit des asynchronen Zählwerkes (12) aufgrund dieser Erfassung auszulösen.

4. Vorrichtung nach einem der Ansprüche 1 bis 3, dadurch gekennzeichnet, daß das genannte Mittel für die systematische Steuerung des lesens besagter Stufen des asynchronen Zählwerkes ein Mittel für das Dekodieren des Zustandes des besagten synchronen Zählwerkes (24$_4$, 57) aufweist.

5. Vorrichtung nach Anspruch 4, dadurch gekennzeichnet, daß die besagten Steuerungsmittel für das systematische Lesen dafür geeignet sind, aufgrund des Überschreitens der vollen Kapazität des synchronen Zählwerkes (10) durch dieses ein Lesesignal zu übertragen.

6. Vorrichtung nach einem der Ansprüche 1 bis 5, dadurch gekennzeichnet, daß besagte Lesemittel ein erstes Register (49) aufweisen, das für das Lesen der Stufen des asynchronen Zählwerkes aufgrund besagter Steuerungsmittel der systematischen Lesung angeschlossen ist.

7. Vorrichtung nach dem Anspruch 6, dadurch gekennzeichnet, daß die Lesemittel ein zweites Register (27) aufweisen, das für die Ablesung der Stufen des synchronen Zählwerkes (10) aufgrund eines Lesebefehles angeschlossen ist.

8. Vorrichtung nach dem Anspruch 7, dadurch gekennzeichnet, daß sie einen ersten Speicher (33) aufweist, um den Zustand besagter erster und zweiter register beim Empfang eines Lesebefehles aufgrund eines Befehls am Beginn der Zählung zu registrieren, und einen zweiten Speicher (35) aufweist, um den Zustand der Register beim Empfang eines Lesebefehls, der einem Befehl am Ende der Zählung entspricht, zu registrieren.

9. Vorrichtung nach dem Anspruch 2, dadurch gekennzeichnet, daß die genannten Lesemittel ein Register (49) aufweisen und die Steuerungsmittel für das systematische Lesen wirksam sind, um das Lesen des Zustandes des asynchronen Zählwerkes in diesem Register aufgrund des Empfanges durch die Zählmittel der Impulse zu steuern, wobei die Kommutation der Stufe von geringster Wertigkeit des asynchronen Zählwerkes ausgelöst wird.

10. Vorrichtung nach Anspruch 9, dadurch gekennzeichnet, daß die Steuerungsmittel für die Kommutation des asynchronen Zählwerkes Mittel (24$_4$) aufweisen, um eine erste Änderung des Zustandes des synchronen Zählwerkes anzugeben und aufgrund dieser Angabe die Kommutation des asynchronen Zählwerkes zu bewirken (16) und daß die Steuerungsmittel für die systematische Lesung Mittel (24$_4$ und 57) aufweisen, um eine zweite, der ersten folgende Änderung des Zustandes des synchronen Zählwerkes (10) anzuzeigen und aufgrund dieser Anzeige die Lesung des Inhaltes des asynchronen Zählwerkes durch das besagte Register zu bewirken (56).

11. Vorrichtung nach Anspruch 10, dadurch gekennzeichnet, daß die zweite Änderung des Zustandes der Kommutation des synchronen Zählwerkes (10) entspricht, entsprechend dem Überschreiten seines Zustandes der vollen Kapazität, und daß die erste Änderung des Zustandes der Kommutation der Stufe von höchster Wertigkeit des synchronen Zählwerkes (10), welche dem Zustand der vollen Kapazität vorausgeht, entspricht.

12. Vorrichtung nach einem der Ansprüche 6, 7 oder 9 oder 11, dadurch gekennzeichnet, daß sie Mittel aufweist, um den Inhalt des Registers (49) der Lesung des asynchronen Zählwerkes (12) aufgrund eines Übertragungsbefehls zu speichern und Mittel (70) aufweist, um das Register der Lesung während der Zeit dieses Speichervorganges zu sperren.

Fig. 1

Fig. 2

0 051 019